# EUROPEAN PATENT APPLICATION

(11) **EP 4 535 664 A1**
(43) Date of publication of application: **09.04.2025**
(21) Application number: 23201597.4
(22) Date of filing: 04.10.2023
(51) Int. Cl.: H03K 17/06, H03K 17/10, H03K 17/693

(54) **RADIOFREQUENCY CIRCUIT, RADIOFREQUENCY SYSTEM AND METHOD FOR A RADIOFREQUENCY CIRCUIT**

(71) Applicant: Infineon Technologies AG, 85579 Neubiberg (DE)
(72) Inventor: VOLPATO, Giovanni, 9500 Villach (AT); CARUSO, Michele, 9584 Finkenstein am Faaker See (AT); TROTTA, Saverio, 80538 München (DE)
(74) Representative: 2SPL Patentanwälte PartG mbB

(57) **Abstract**

It is proposed an RF circuit comprising an input node configured to receive an RF signal, an output node configured to output the RF signal, an RF switch assembly coupled between the input node and the output node, wherein the RF switch assembly is configured to selectively connect or disconnect the input node and the output node, and wherein the RF switch assembly comprises a first stage comprising a first RF switch and a second stage comprising a second RF switch, wherein the first stage is configured, in an off state of the RF switch assembly in which the first stage and the second stage are in an off state, to attenuate a signal power of the RF signal or isolate the output node against the input node.

## Description

### Field

The present disclosure relates to radiofrequency (RF) switches. Examples relate to an RF circuit, an RF system and a method for an RF circuit.

### Background

RF switches are fundamental components in various electronic systems, including radar systems. In many applications, it is essential to achieve a high degree of isolation between the connected and disconnected paths to prevent unwanted signal leakage and interference. However, with conventional RF switch circuits, particularly when operating at high power levels, an adverse effect on isolation performance may occur: when a switch is in the off state, it is expected to exhibit minimal or negligible signal conduction between the input and output ports. However, as input power levels increase, a significant voltage swing can occur across the switch. This voltage swing can induce unwanted electrical breakdown and unintended conduction between the switch terminals, thereby compromising isolation. Hence, there is a need for an improved RF switch circuit.

### Summary

This need is satisfied by the subject matter of the independent claims.

Some aspects of the present disclosure relate to an RF circuit comprising an input node configured to receive an RF signal, an output node configured to output the RF signal, an RF switch assembly coupled between the input node and the output node, wherein the RF switch assembly is configured to selectively connect or disconnect the input node and the output node, and wherein the RF switch assembly comprises a first stage comprising a first RF switch, and a second stage comprising a second RF switch, wherein the first stage is configured, in an off state of the RF switch assembly in which the first stage and the second stage are in an off state, to attenuate a signal power of the RF signal or isolate the output node against the input node.

Some aspects of the present disclosure relate to a method for an RF circuit, the RF circuit comprising an RF switch assembly comprising a first stage and a second stage coupled between an input node and an output node, the first stage comprising a first RF switch and the second stage comprising a second RF switch, the method comprising receiving, at the input node, an RF signal, selectively connecting or disconnecting, by the RF switch assembly, the input node and the output node, selectively outputting, at the output node, the RF signal, and in an off state of the RF switch assembly in which the first stage and the second stage are in an off state, attenuating, at the first stage, a signal power of the RF signal or isolating, at the first stage, the output node against the input node.

### Brief description of the Figures

Some examples of apparatuses and/or methods will be described in the following by way of example only, and with reference to the accompanying figures, in which
Fig. 1a and Fig. 1b illustrate an example of an RF circuit in an off state and an on state, respectively;
Figs. 2a to 2g illustrate examples of an RF circuit with different topologies;
Fig. 3 illustrates an example of an RF circuit with a resonator;
Fig. 4 illustrates an example of an RF circuit with a transformer;
Fig. 5 illustrates an example of an RF system;
Fig. 6 illustrates an example of an RF system with shared amplifiers;
Fig. 7 illustrates an example of an RF system with shared antennas; and
Fig. 8 illustrates an example of a method for an RF circuit.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

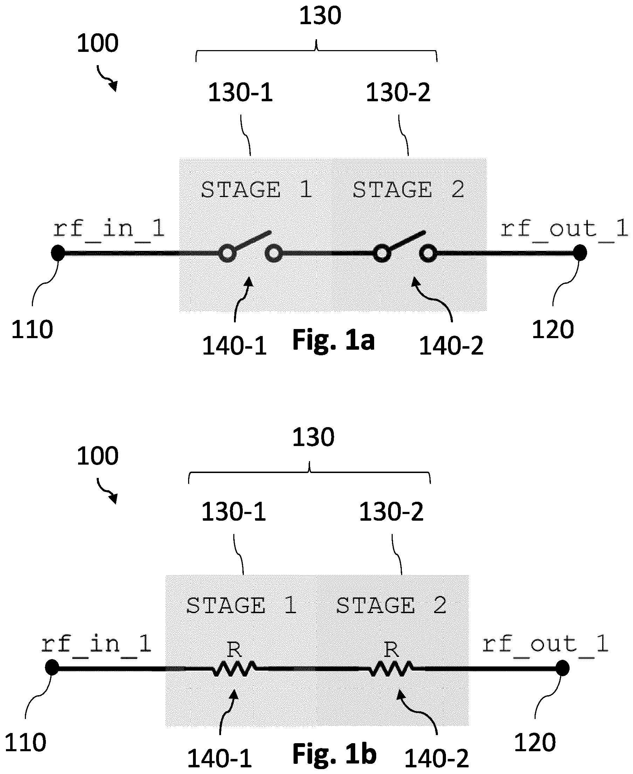

**Fig. 1a** and **Fig. 1b** illustrate an RF circuit 100 in an off state and in an on state, respectively. The RF circuit 100 is an electronic circuit designed to operate with an RF signal, i.e., a signal in the radio frequency range, spanning from, e.g., a few kilohertz (kHz) to hundreds of gigahertz (GHz). The RF circuit 100 may provide the RF signal for any RF application such as wireless communication systems, television broadcasts, cellular phones, Wi-Fi (Wireless-Fidelity) networks, radar systems, and satellite communication systems. The RF circuit 100 may be integrated into such a system or device or may alternatively be external to it and coupled to it via a wired or wireless connection.

The RF circuit 100 comprises an (RF) input node 110 configured to receive an RF signal (rf-in-1). The input node 110 may be a point, interface or terminal within the RF circuit 100 where an external RF signal, e.g., in form of a voltage or current, is applied to the RF circuit 100. The input nodes 110 may serve as an entry point for the RF signal into the RF circuit 100 and may be connected to other RF components depending on the specific application, e.g., to an RF antenna, filter, amplifier, mixer, oscillator or alike.

The RF circuit 100 further comprises an (RF) output node 120 configured to output the RF signal (rf-out-1). The output node 120 may be a point, interface or terminal within the RF circuit 100 where the RF circuit 100 delivers its output RF signal, voltage or current to an external device or component, e.g., to an RF antenna, filter, amplifier, mixer, oscillator or alike. Depending on the state of the RF circuit 100, the output node 120 may either output the RF signal as received at the input node 110 (after deducting losses due to the RF circuit 100) or may substantially output no signal. Specifically, in an off state (Fig. 1a), the RF circuit 100 may isolate the output node 120 from the input node 110, whereas in an on state (Fig. 1b), the RF circuit 100 may pass through the RF signal form the input node 110 to the output node 120.

This is realized by an RF switch assembly 130 of the RF circuit 100 coupled between the input node 110 and the output node 120. For instance, the RF switch assembly 130 may be electrically coupled to the input node 110 and the output node 120 via electrical connections. The RF switch assembly 130 is configured to selectively connect or disconnect the input node 110 and the output node 120, yielding an on state and an off state, respectively. The selection of a connection or disconnection may be controlled automatically, e.g., by using a control signal or digital logic in the RF circuit 100.

The RF switch assembly 130 comprises a first stage 130-1 comprising a first RF switch 140-1 and a second stage 130-2 comprising a second RF switch 140-2. The term "stage" refers to a functional section or block within the RF circuit 100 that performs a switching function. The stages 130-1, 130-2 are characterized by including at least one respective RF switch, such as RF switch 140-1, 140-2, respectively. The first stage 130-1 and the second stage 130-2 are electrically coupled to one another. They may be directly coupled to one another, i.e. without an intermediate component between them, or alternatively indirectly coupled, i.e. with intermediate components in between. The first stage 130-1 may be (e.g., directly) coupled to the input node 110, whereas the second stage 130-2 may be (e.g., directly) coupled to the output node 120. For example, the first stage 130-1 and the second stage 130-2 may be adjacent within the RF circuit 100. This means that the first stage 130-1 and the second stage 130-2 may be physically positioned in close proximity on the circuit board implementing the RF circuit 100 or within the RF circuit's schematic diagram. This physical proximity or direct connection implies that the first stage 130-1 and the second stage 130-2 share a common connection point (node), such as being connected by a conductive trace or by a wire.

The first RF switch 140-1 and the second RF switch 140-2 may be any switch designed for routing RF signals. They may be or may comprise a transistor and/or a diode switch and switch between conduction and isolation/attenuation between their respective terminals, e.g., based on a control signal applied to respective control terminals of the RF switches 140-1, 140-2. The RF switches 140-1, 140-2 may comprise at least one of a positive intrinsic negative (PIN) diode, a bipolar transistor (e.g., npn or pnp transistor) or a unipolar transistor (e.g., Junction Type Field-Effect Transistor, JFET, Metal-Oxide-Semiconductor Field-Effect Transistor, MOSFET, Gallium Arsenide Field-Effect Transistor, GaAs FET). The first RF switch 140-1 and the second RF switch 140-2 are not necessarily of the same type. Different configurations with respect to the implementation of the first RF switch 140-1 and the second RF switch 140-2 in their respective stages 130-1, 130-2 are explained further below.

The off state of the RF switch assembly 130 shown in Fig. 1a indicates that the first stage 130-1 and the second stage 130-2 are both in an off state. That is, the first RF switch 140-1 is either on or off - depending on its configuration and type - such that the first stage 130-1 is in an off state. Likewise, the second RF switch 140-2 is either on or off - depending on its configuration and type - such that the second stage 130-2 is in an off state.

The first stage 130-1 is configured, in the off state of the RF switch assembly 130, to attenuate a signal power of the RF signal or isolate the output node 120 against the input node 110. In the latter case, full isolation may already be provided by the first stage 130-1. In the former case, the first stage 130-1 outputs an attenuated RF signal at its output terminal, full isolation may then be provided by the second stage 130-2 which is then tasked with handling a lower signal swing (the attenuated RF signal). In other words, when the RF switch assembly 130 is off (isolating), the first stage 130-1 attenuates the signal power which is received by the second stage 130-2 which consequently can provide a high isolation. Whether the former or the latter applies may depend on the power of the RF signal.

When the RF switch assembly 130 is in an on state (conducting) as shown in Fig. 1b, both stages 130-1, 130-2 may be conducting and causing an insertion loss.

Each stage 130-1, 130-2 of the RF circuit 100 may be realized with a basic switch topology or a more complex topology addressing different requirements of the target application. More details about the configurations or topologies of the stages 130-1, 130-2 are explained in the following:
At least one of the first stage 130-1 and the second stage 130-2 may comprise a shunt switch or a series switch. For instance, the first RF switch 140-1 may be a shunt switch or a series switch, and the second RF switch 140-2 may be a shunt switch or a series switch. The shunt switch may be a type of switch where the switching element is connected in parallel to or shunt with the signal path of the RF signal (signal path between input node 110 and output node 120) or the output node 120 coupled to a load. When the shunt switch is in its on state, it provides a low-resistance path for the RF signal to flow in parallel with the load, effectively bypassing it. Conversely, when the shunt switch is in its off state, it presents a high resistance or an open circuit, preventing the RF signal from being cut off in its flow to the output node 120. The series switch may be a type of switch where the switching element is connected in series with the output node 120 or the signal path of the RF signal. When the series switch is in its on state, it forms a continuous conductive path with the output node 120 and to a load coupled thereto, allowing the RF signal to flow through both the switch and the load. In the off state, the series switch interrupts the path, creating an open circuit and preventing the RF signal flow to the output node 120.

To combine both topologies, a shunt switch and a series switch, one of the first stage 130-1 and the second stage 130-2 comprises a shunt switch, and the other one of the first stage 130-1 and the second stage 130-2 comprises a series switch. For example, the first stage 130-1 may comprise a shunt switch, and the second stage 130-2 may comprise a series switch. Then, the shunt switch may attenuate the power of the RF signal, whereas the series switch may cut off the attenuated RF signal from the output node 120. Alternatively, the stages 130-1, 130-2 may comprise RF switches of the same type.

One or both of the RF switches 140-1, 140-2 may be resonated by an inductor. The RF circuit 100 may therefore comprise an inductor coupled in parallel to at least one of the first RF switch 140-1 and the second RF switch 140-2. The inductor may be a resonant inductor to create a resonant frequency response which is adapted to a capacity of the associated RF switch. Thereby, it may form a resonant LC (inductor-capacitor) circuit with an inductive reactance and a capacitive reactance of equal magnitude but opposite phases, which results in cancellation of their effects.

A quarter-wave (λ/4) transmission line may be optionally used. This may be especially useful for high frequency where the quarter-wave transmission line has a smaller size. The quarter-wave transmission line (also quarter-wave line or quarter-wavelength transmission line) is a specific type of transmission line that has a length equal to one-fourth (1/4) of the wavelength of the electromagnetic wave (the RF signal) propagating through it at a particular frequency. In this way, the quarter-wave line introduces a 90-degree phase shift in the RF signal, which alters the impedance seen at the junction point. The quarter-wave transmission line may be used for impedance matching, signal transformation or alike. The quarter-wave transmission line may be combined with a shunt switch: Thus, at least one of the first stage 130-1 and the second stage 130-2 may comprise a shunt switch and a quarter-wave transmission line. The quarter-wave transmission line may, e.g., be connected in series to the signal path between the input node 110 and the output node 120.

One or each of the stages 130-1, 130-2 may optionally comprise more than one RF switch. For example, the above quarter-wave transmission line may be replaced by a series switch which may be in particular advantageous for lower frequencies or when area consumption is critical. Apart from that, a series switch and a shunt switch may be generally combined within one or both of the stages 130-1, 130-2 to improve the isolation characteristics. In such cases, at least one of the first stage 130-1 and the second stage 130-2 comprises a series switch and a shunt switch.

Depending on the specific use case, the RF switch assembly 130 may serve purposes such as distributing one transmitter signal to multiple antennas, sharing one receiver signal among several antennas, or enabling a single antenna to be used for both transmission and reception. In all of these scenarios, the RF circuit 100 may offer low insertion loss and high isolation, even when dealing with substantial input power levels. This is due to its two stages which may operate in a coordinated manner.

Particularly in radar systems, where the intended application may require multiple transmitters and receivers, there may be a challenge regarding the area consumption and subsequently elevated costs associated with having numerous independent transmitters or receivers. A conventional solution that allows for the sharing of a single transmitter or receiver across multiple antennas is the use of basic, i.e., single-stage, switch topologies, such as a series switch. However, this conventional approach may be suited only for specific applications such as where the linearity requirement is not stringent, e.g., when distributing one receiver signal to multiple antennas. It may however be unacceptable in other applications where linearity (or power handling) is critical. The reason for this limitation lies in the fact that, under high input power conditions of the RF signal, there is a significant voltage swing across the off-state switch. Consequently, the switch starts to conduct, which compromises its isolation. Another conventional topology is a quarter-wavelength transmission line-based switch. Unfortunately, it may share the same drawback in terms of power handling, as under high input power, the off-state shunt switch begins to conduct, affecting its insertion loss in the on-state. Thus, these approaches are not suitable to be used at a transmitter output. Another conventional approach involves the use of specialized technologies, such as CMOS SOI (Complementary Metal-Oxide-Semiconductor Silicon-On-Insulator) or MEMS (Micro-Electro-Mechanical Systems). However, these solutions come with certain disadvantages, including increased costs, larger system footprint due to multi-technology integration, heightened complexity, or trade-offs in other aspects like digital design. By contrast, the RF circuit 100 may provide high isolation and low insertion loss while still keeping the cost and footprint relatively low.

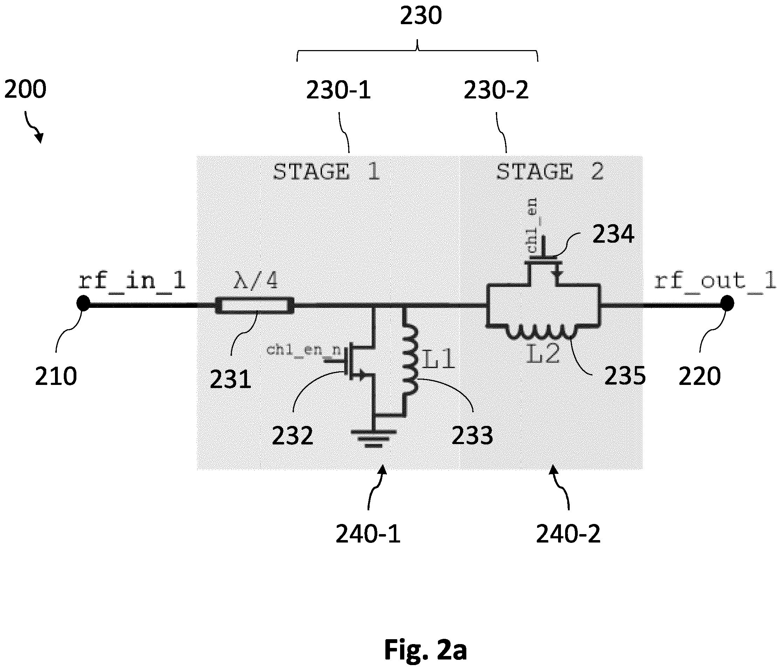

Several topologies of the RF circuit 100 are illustrated by Figs. 2a to 2g. **Figs. 2a to 2g** show examples of an RF circuit 200.

In Fig. 2a, the first stage 230-1 comprises a quarter-wave transmission line 231 directly coupled to the input node 210 and a shunt switch 232 (first RF switch 240-1) coupled in parallel to the signal path (channel 1) between input node 210 and output node 220. The use of the quarter-wave transmission line 231 may be beneficial for high frequencies, where the quarter-wave transmission line 231 has a smaller size.

One terminal of the shunt switch 232 is directly coupled between the quarter-ware transmission line 231 and the second stage 230-2. The shunt switch 232 is resonated, i.e., coupled in parallel to an inductor 233. In the example of Fig. 2a, the shunt switch 232 comprises an n-channel MOSFET as switching element. The shunt switch 232 is controlled by a control signal applied to the gate of the MOSFET (ch1_en_n; inverted channel 1 enable signal).

In Fig. 2a, the second stage 230-1 comprises a series switch 234 (the second RF switch 240-2) directly coupled between the terminal of the shunt switch 232 and the output node 220. The series switch 234 is resonated, i.e., coupled in parallel to an inductor 235. In the example of Fig. 2a, the series switch 234 comprises an n-channel MOSFET as switching element. The series switch 234 is controlled by a control signal applied to the gate of the MOSFET (ch1_en; channel 1 enable signal).

In the off state of the RF switch assembly 230, the control signal may control the shunt switch 232 to be in a conducting state, and thus the shunt switch 232 may bypass the RF signal or part of it to ground. At the second stage 230-2, either no signal or an attenuated RF signal may be received. The control signal of the series switch 234 may control the series switch 234 to be in an isolating state, and thus the series switch 234 may provide an additional isolation between the input node 210 and the output node 220. The control signal of the shunt switch 232 and the control signal of the series switch 234 may be synchronized and inverted to each other.

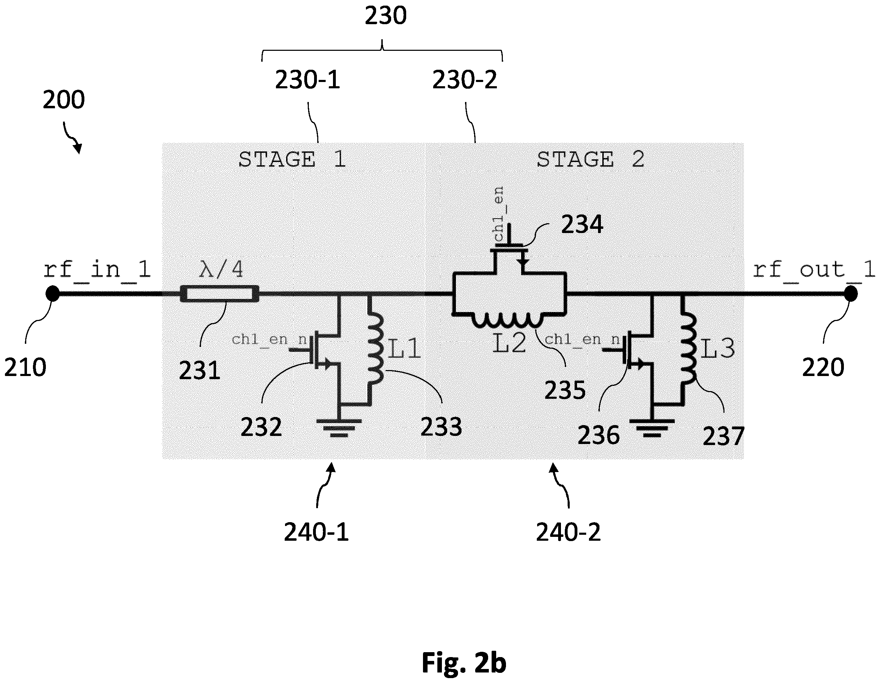

In Fig. 2b, the first stage 230-1 corresponds to the first stage 230-1 of Fig. 2a. The second stage 230-1 comprises, in addition to the resonated shunt switch 234 of Fig. 2a, a second (further) shunt switch 236 coupled in parallel to the signal path. One terminal of the second shunt switch 236 is directly coupled between the series switch 234 and the output node 220. Another terminal of the second shunt switch 236 is connected to ground. The shunt switch 236 is resonated, i.e., coupled in parallel to an inductor 237.

In the example of Fig. 2b, the shunt switch 236 comprises an n-channel MOSFET as switching element. The shunt switch 236 is controlled by a control signal applied to the gate of the MOSFET (ch1_en_n; inverted channel 1 enable signal). The additional shunt switch 236 provides an even higher isolation between the input node 210 and the output node 220. This may be especially beneficial in applications where the isolation requirement is high. The use of multiple switches may enable a control of RF switching in a more granular and secure manner. The control signals of the multiple switches may be interlocked to jointly trigger the required states of the respective switches, for either realizing an on or off state of the RF switch assembly 230.

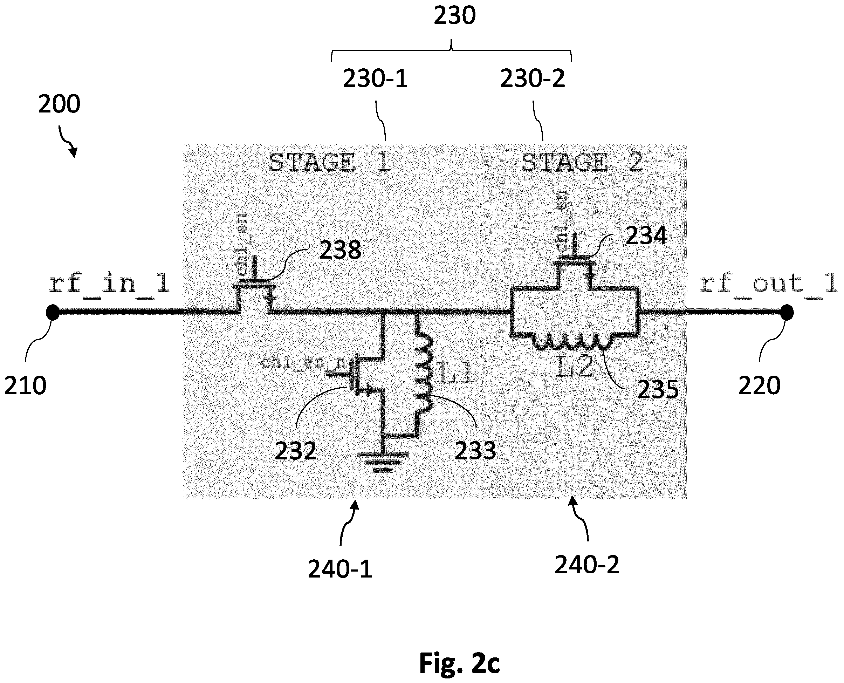

In Fig. 2c, the second stage 230-2 corresponds to the second stage 230-1 of Fig. 2a. The first stage 230-1 comprises a resonated shunt switch 234 as in Fig. 2a, but instead of a quarter-wave transmission line 231, an un-resonated series switch 238 is used. The series switch 238 is directly coupled between the input node 210 and a terminal of the shunt switch 232. In the example of Fig. 2c, the series switch 238 comprises an n-channel MOSFET as switching element. The series switch 238 is controlled by a control signal applied to the gate of the MOSFET (ch1_en; channel 1 enable signal). In the example of Fig. 2c, the first stage 230-1 thus comprises a series switch 238 followed by a shunt switch 232, while the second stage 230-2 comprises a series switch 234.

The (first) series switch 238 does not need to be resonated, because for high-power RF signals the resonance may be ineffective due to the partial turn-on of the series switch 238 caused by the high-power input signal (RF signal). The use of the series switch 238 may be particularly beneficial when area is critical or at lower frequencies where a series switch may perform better, and a transmission line may be too bulky.

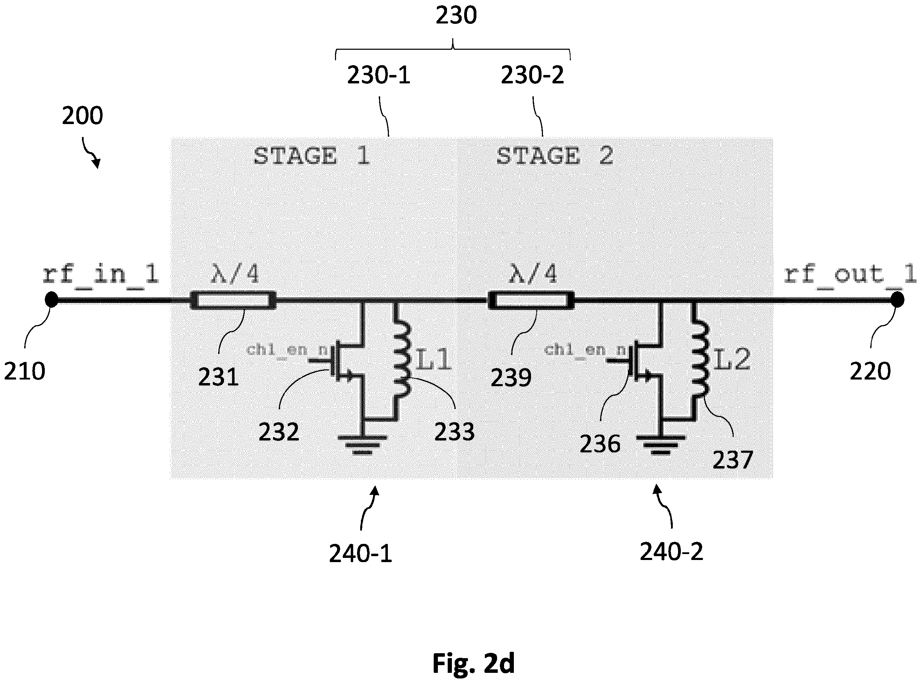

In Fig. 2d, the first stage 230-1 corresponds to the first stage 230-1 of Fig. 2a or Fig. 2b. The second stage 230-2 comprises a second resonated shunt switch 236 as in Fig. 2b, but instead of a series switch 234, the second stage 230-2 comprises a second (further) quarter-wave transmission line 239. This may be beneficial in applications with lower area constraints or at higher frequencies.

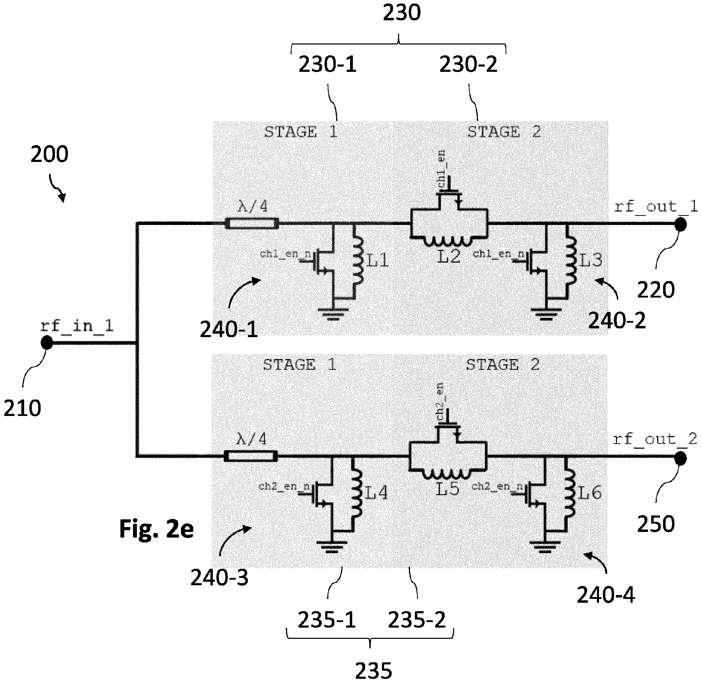

Referring back to Fig. 1a and Fig. 1b, as mentioned above, the RF circuit 100 may be implemented in a multi path or multi channel environment to share components, e.g., antennas between receiver and transmitter or a receiver/transmitter between antennas or alike. In these cases, the RF circuit 100 may further comprise a second output node configured to output the RF signal and a second RF switch assembly coupled between the input node and the second output node. The second RF switch assembly comprises a third stage comprising a third RF switch and a fourth stage comprising a fourth RF switch. This is illustrated by Figs. 2e to 2g.

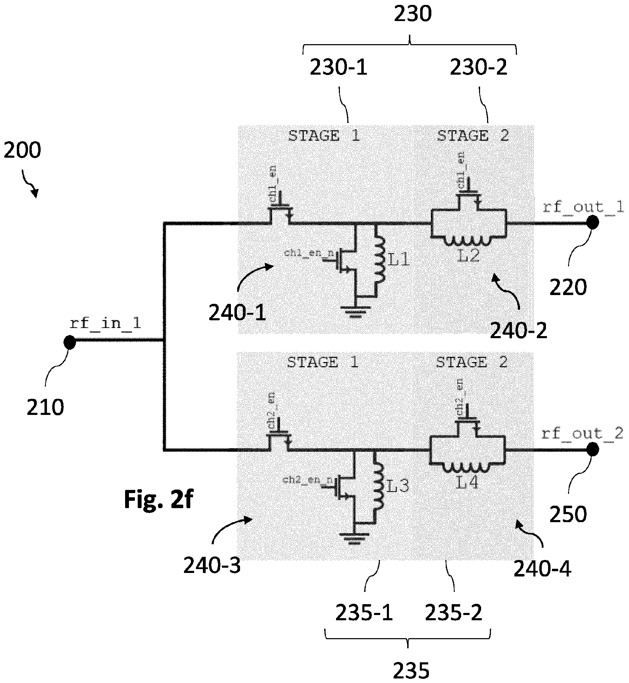

In Fig. 2e and Fig. 2f, the RF switch assembly 230 corresponds to the topology of Fig. 2b and Fig. 2c, respectively. The signal path between the input node 210 and the output node 220 form a first channel of the RF circuit 200. The RF circuit 200 further comprises a second output node 250 configured to output the RF signal. The signal path between the input node 210 and the second output node 250 form a second channel of the RF circuit 200. The RF circuit 200 further comprises a second RF switch assembly 235 coupled between the input node 210 and the second output node 250. The second RF switch assembly 235 comprises a third stage 230-3 comprising a third RF switch 240-3 and a fourth stage 230-4 comprising a fourth RF switch 240-4. The topology of the second RF switch assembly 235 corresponds to the topology of the RF switch assembly 230. The first and the second channel of the RF circuit 200 may be independently controllable. This may be realized by a second control signal used for the switches of the second RF switch assembly 235.

The multi channel configuration, such as in Fig. 2e and Fig. 2f, may be used to create an SPDT (Single Pole Double Throw) switch, e.g., to share one transmitter between two (or more) antennas. The configuration of Fig. 2e is especially beneficial at higher frequencies, where a quarter-lambda transmission line has a smaller size. The configuration of Fig. 2f is especially beneficial at lower frequencies or when area consumption is critical.

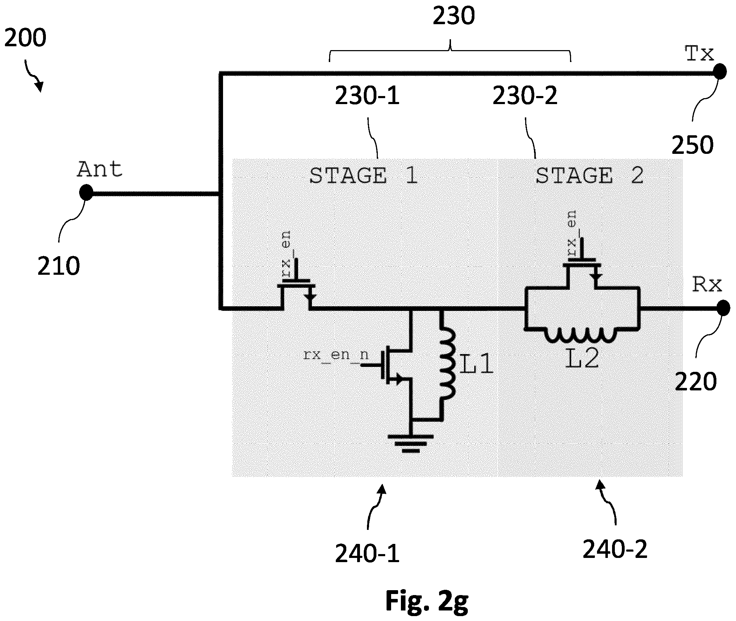

In Fig. 2g, the topology of the RF switch assembly 230 corresponds to the topology of Fig. 2c. The output node 220 is connected to a receiver circuit Rx. The input node 210 is connected to an antenna. The second output node 250 is directly connected to the input node 210 to minimize losses, while the RF switch assembly 230 is placed between antenna and receiver. In this configuration, the RF switch assembly 230 protects the receiver input in addition to providing isolation. In other examples, a different topology for the RF switch assembly 230 than the one of Fig. 2c may be used, such as the topology of Fig. 2a.

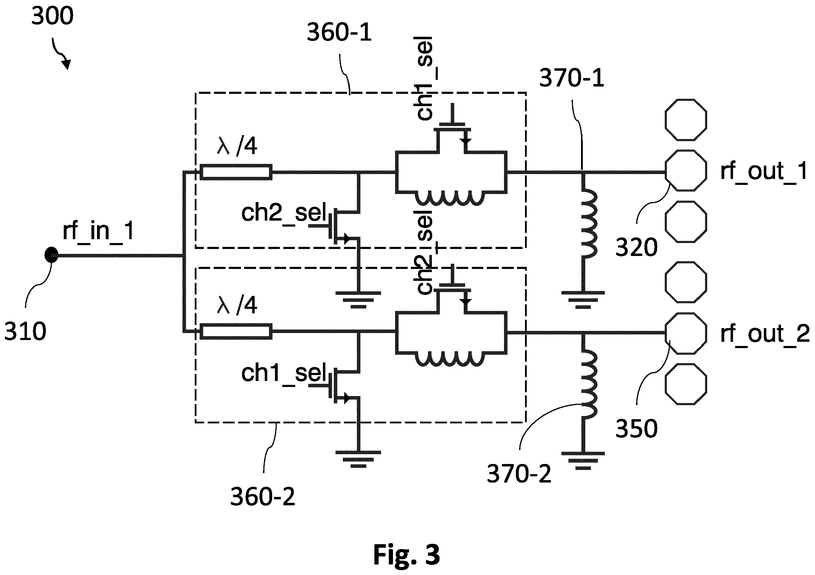

Referring back to Fig. 1a and Fig. 1b, the RF circuit 100 may also require ESD (electrostatic discharge) protection or other tuning of electronic characteristics of the RF circuit 100 (such as resonance). In such cases, the RF circuit 100 may comprise a (resonant) stub or a pad stub coupled between the output node 120 and the RF switch assembly 130. The resonator is a transmission line or resonant element which may have a short length of transmission line, e.g., of one-quarter of the wavelength of the RF signal it is designed to resonate at. The resonator may be coupled in parallel with the signal path and may be connected to ground. An example of a usage of a resonator is illustrated by Fig. 3. **Fig. 3****,** which shows an example of an RF circuit 300.

The RF circuit 300 comprises an input node 310 configured to receive an RF signal. The RF circuit 300 comprises two channels with a respective output node, a first output node 320 and a second output node 350, both configured to output the RF signal. In the example of Fig. 3, the output nodes 320, 350 are two of multiple pads.

The RF circuit 300 further comprises two RF switch assemblies 360-1, 360-2 as described herein, such as RF switch assembly 100. In Fig. 3, the RF switch assemblies 360-1, 360-2 exhibit the topology of the RF-switch assembly of Fig. 2a. The RF switch assemblies 360-1, 360-2 are coupled between the input node 310 and a respective output node 320 and 350.

The RF circuit 300 further comprises two resonators 370-1, 370-2. The first resonator 370-1 is directly coupled between the first output node 320 and the first RF switch assembly 360-1, the second resonator 370-2 is directly coupled between the second output node 350 and the second RF switch assembly 360-2. The resonators 370-1, 370-2 at the pads may aggregate resonant inductors of the switches in the RF circuit 300 and may provide additional impedance matching or tuning.

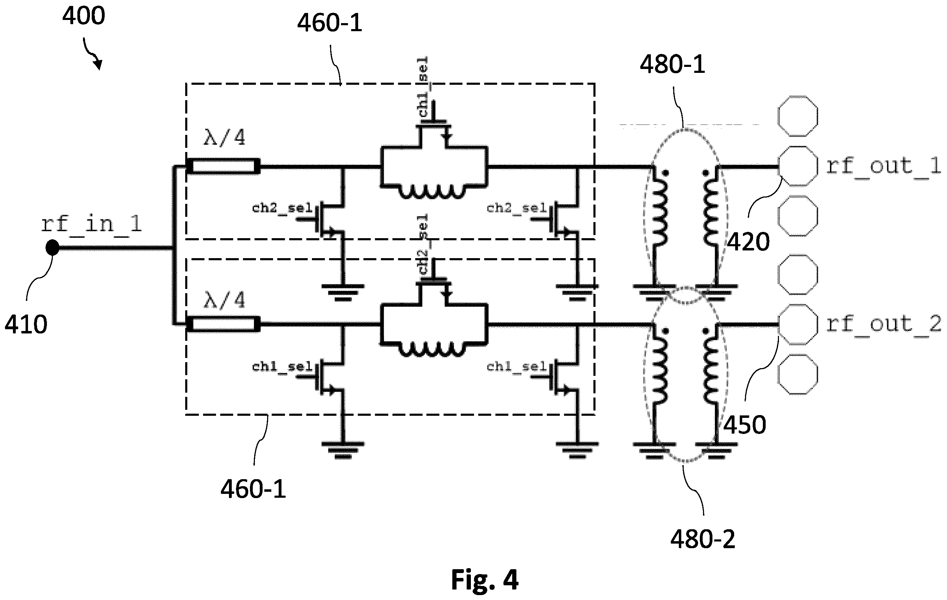

Another option to realize ESD protection may be realized in the following way: In addition to a resonator or as an alternative thereto, the RF circuit 100 may further comprise a transformer coupled between the output node 120 and the RF switch assembly 130. An example of a usage of a transformer is illustrated by Fig. 4. **Fig. 4** shows an example of an RF circuit 400.

The RF circuit 400 comprises an input node 410 configured to receive an RF signal. The RF circuit 400 comprises two channels with a respective output node, a first output node 420 and a second output node 450, both configured to transmit the RF signal. In the example of Fig. 4, the output nodes 420, 450 are two of multiple pads.

The RF circuit 400 further comprises two RF switch assemblies 460-1, 460-2 as described herein, such as RF switch assembly 100. In Fig. 4, the RF switch assemblies 460-1, 460-2 exhibit the topology of the RF-switch assembly of Fig. 2e. The RF switch assemblies 460-1, 460-2 are coupled between the input node 410 and a respective output node 420 and 450.

The RF circuit 400 further comprises two transformers 480-1, 480-2. The first transformer 480-1 is directly coupled between the first output node 420 and the first RF switch assembly 460-1, the second transformer 480-2 is directly coupled between the second output node 450 and the second RF switch assembly 460-2. The transformers 480-1, 480-2 at the pads may replace a stub and resonate the off-state capacity. It may increase ESD protection without the usage of anti-parallel diodes.

The RF circuit presented herein has the potential to decrease the chip area within RF systems by enabling the sharing of certain electrical components. Additionally, this RF circuit offers high linearity, enhanced power handling capabilities, and significant isolation between components. Moreover, it can be implemented with cost-effectiveness and without introducing excessive complexity.

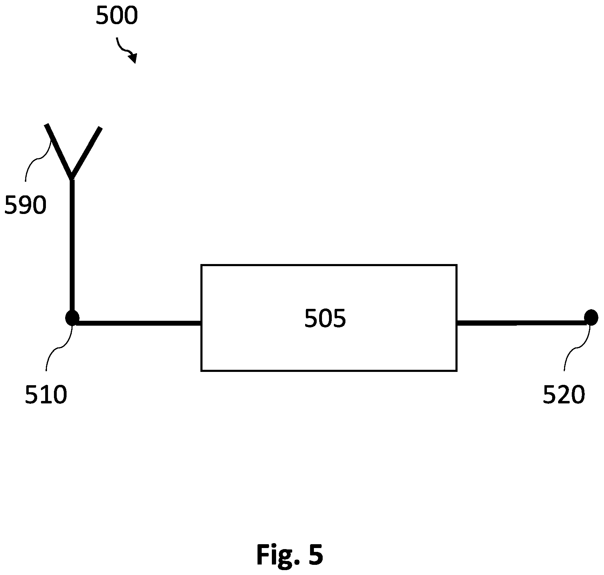

**Fig. 5** illustrates an example of an RF system 500. The RF system 500 may be a radar system such as an FMCW (Frequency-Modulated Continuous Wave) radar system, for instance. The RF system 500 comprises an RF circuit 505 as described herein, such as RF circuit 100, and an antenna 590 coupled to the input node 510. The antenna 590 is configured to generate the RF signal, e.g., based on a received free space wave. Thus, the antenna 590 is a receiving antenna. Alternatively, the antenna 590 may be (directly) coupled to the output node 520. In such cases, the antenna 590 may be configured to receive the RF signal, e.g., for transmission through free space. In the latter case, the antenna 590 may be a transmitting antenna. In some examples, the antenna 590 may be a receiving and transmitting antenna, i.e., in cases where the antenna 590 is shared between a receiver and a transmitter.

The RF system 500 may further comprise at least one of an amplifier circuit and a passive mixer coupled to the other one of the output node 520 and the input node 510. That is, at the end of the RF circuit 505 opposite to the antenna 590, an amplifier circuit or a passive mixer may be implemented. In the example of Fig. 5, the at least one of the amplifier circuit and the passive mixer may be coupled to the output node 520. The amplifier circuit or the passive mixer may be shared among the antenna 590 and other antennas.

The passive mixer is an electronic component or circuit used to combine or mix two or more RF signals together. The passive mixer may exclusively rely on passive components like diodes or resistors for the mixing process. It may be beneficial in applications where simplicity and low power consumption are more critical than high gain. The amplifier circuit may be or comprise a power amplifier or a low-noise amplifier. The power amplifier is an electronic device or circuit that increases the amplitude (power) of an input signal to a higher level, yielding the RF for the purpose of driving the antenna 590. The low-noise amplifier (LNA) is an electronic amplifier designed to amplify weak signals with minimal added noise. LNAs may be used at the front end of RF receivers to increase the sensitivity of the receiver.

For bidirectional use of the antenna 590, the RF circuit 505 may be implemented as a time division duplex (TDD) switch. The TDD switch may use the same frequency for both transmitting and receiving an RF signal and alternate between these two functions in a time-based and synchronized manner.

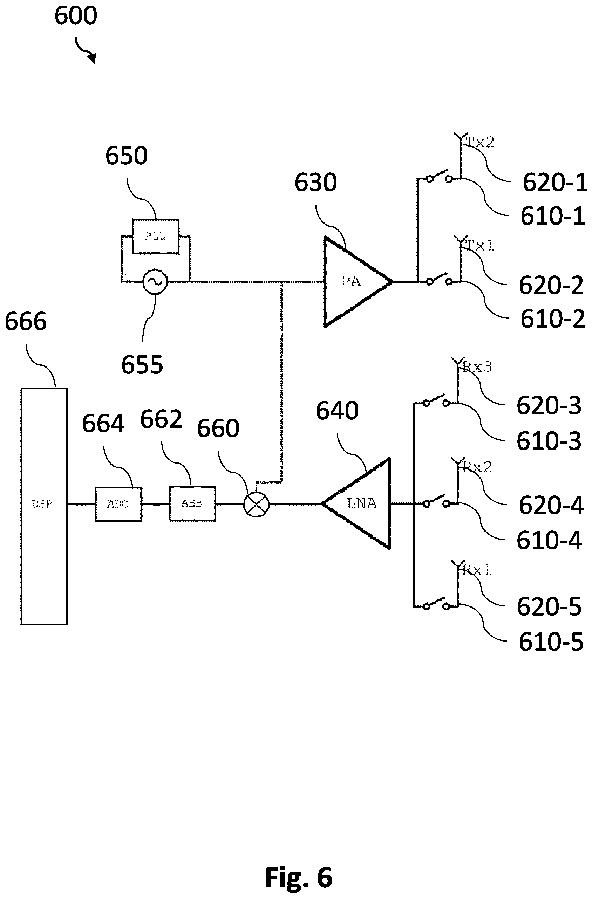

The above-mentioned multi-channel application may be realized by introducing a plurality of RF circuits as described herein, including the RF circuit 505. The plurality of RF circuits are coupled to the at least one of the amplifier circuit and the passive mixer, i.e., the plurality of RF circuits share one amplifier circuit or passive mixer. The RF system 500 may further comprise a plurality of antennas, each coupled to a respective RF circuit of the plurality of RF circuits. An example of a multi-channel application is illustrated by Fig. 6.

**Fig. 6** shows an example of an RF system 600. The RF system 600 comprises a plurality of RF circuits 610-1 to 610-5, each of the plurality of RF circuits 610-1 to 610-5 is an RF circuit as described herein, such as RF circuit 100. The RF system 600 further comprises a plurality of antennas 620-1 to 620-5, each of the plurality of antennas 620-1 to 620-5 is an antenna as described above with reference to Fig. 5. The antennas 620-1 and 620-2 are transmitting antennas (Tx), whereas the antennas 620-3 to 620-5 are receiving antennas (Rx). Each antenna of the plurality of antennas 620-1 to 620-5 is coupled to a respective RF circuit of the plurality of RF circuits 610-1 to 610-5.

The transmitting antennas 620-1, 620-2 share a power amplifier 630 which is coupled to the RF circuits 610-1, 610-2. The receiving antennas 620-3 to 620-5 share an LNA 640 which is coupled to the RF circuits 610-3 to 610-5. The power amplifier 630 is further coupled to a phased-locked loop (PLL) 650 parallel to an oscillator 655 for generating an RF signal. The oscillator, e.g., a voltage-controlled oscillator (VCO), may generate a carrier frequency signal for the RF system 600. The PLL 650 may control and stabilize the frequency of the oscillator 655, e.g., by comparing the output frequency of the oscillator 655 with a reference frequency (e.g., of a crystal oscillator).

The LNA 640 is further coupled to a mixer 660 connected to the PLL 650 and the oscillator 655. Upstream to the mixer 660, the LNA 640 is further coupled to an analog baseband circuit 662, an Analog-to-Digital Converter (ADC) 664 and a Digital Signal Processing (DSP) circuit 666.

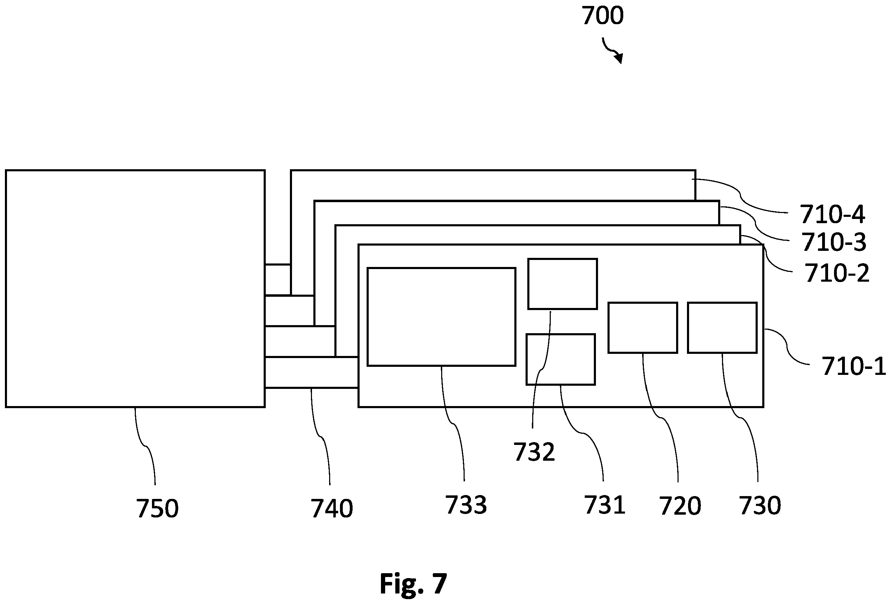

**Fig. 7** illustrates an example of an RF system 700 as TDD system which may serve as an RF front end, e.g., a 5G RF front end. Thus, in the example of Fig. 7, the RF circuits as described herein may be used to share one antenna between transmitter and receiver.

The RF system 700 comprises a plurality of RF front ends 710-1 to 710-4, each coupled to a respective antenna (not shown in Fig. 7). Each of the plurality of RF front ends 710-1 to 710-4 comprises a respective RF circuit 720 as described herein. The RF circuit 720 is configured as a TDD switch. The RF circuit 720 is coupled to a filter 730, one or more power amplifier 731 and an LNA 732. The TDD switch may enable switching between the power amplifier 731 and the LNA 732 in a time-dependent manner in order to use the antenna as transmitting or receiving antenna, respectively. The power amplifier 731 and the LNA 732 are both coupled to a transceiver 733 which generates or receives the RF signal. The RF front ends 710-1 to 710-4 are further coupled via respective ADCs and DACs (Digital-to-Analog Converters) to a DSP circuit 750.

The RF system 700 may optionally comprise a baseband processor. The baseband processor may comprise the DSP circuit 750, for instance. It may be responsible for handling and processing the baseband signals, i.e., signals at their original frequency range before being modulated onto a carrier frequency for transmission or signals after being demodulated from the received RF signal. The baseband processor may be a digital signal processing unit or integrated circuit (IC) within the RF system 700 that manages and processes baseband signals. Baseband signals may represent data or information in its original form, e.g., in the form of digital bits or analog signals within a specified frequency range. The baseband processor may be configured to modulate digital data onto a carrier signal for transmission and demodulate received signals to extract the original baseband data. It may further be configured to perform error correction, e.g., error coding and decoding to ensure reliable data transmission, signal filtering, digital signal processing, data formatting and framing or alike.

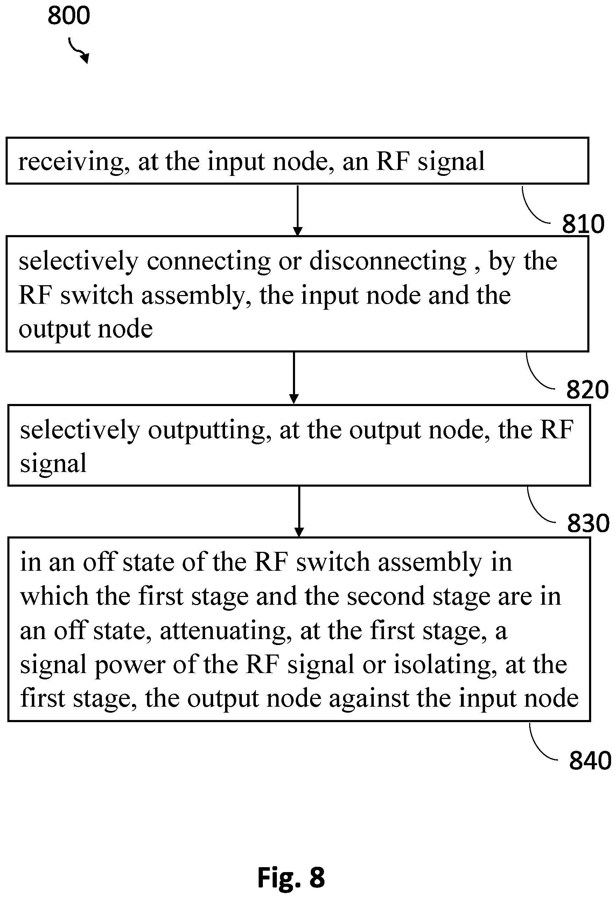

**Fig. 8** illustrates an example of a method for an RF circuit as described herein, such as RF circuit 100, 200, 300 or 400. The method 800 comprises receiving 810, at the input node of the RF circuit, an RF signal and selectively connecting or disconnecting 820, by the RF switch assembly, the input node and the output node. The method 800 further comprises selectively outputting 830, at the output node, the RF signal and, in an off state of the RF switch assembly in which the first stage and the second stage are in an off state, attenuating 840, at the first stage, a signal power of the RF signal or isolating, at the first stage, the output node against the input node.

More details and aspects of the method 800 are explained in connection with the proposed technique or one or more examples described above, e.g., with reference to Fig. 1. The method 800 may comprise one or more additional optional features corresponding to one or more aspects of the proposed technique, or one or more examples described above.

In the following, some examples of the proposed technique are presented:
An example (e.g., example 1) relates to an RF circuit comprising an input node configured to receive an RF signal, an output node configured to output the RF signal, an RF switch assembly coupled between the input node and the output node, wherein the RF switch assembly is configured to selectively connect or disconnect the input node and the output node, and wherein the RF switch assembly comprises a first stage comprising a first RF switch, and a second stage comprising a second RF switch, wherein the first stage is configured, in an off state of the RF switch assembly in which the first stage and the second stage are in an off state, to attenuate a signal power of the RF signal or isolate the output node against the input node.

Another example (e.g., example 2) relates to a previous example (e.g., example 1) or to any other example, further comprising that the first stage and the second stage are directly coupled to one another, the first stage and the second stage being adjacent within the RF circuit.

Another example (e.g., example 3) relates to a previous example (e.g., one of the examples 1 or 2) or to any other example, further comprising that at least one of the first stage and the second stage comprises a shunt switch or a series switch.

Another example (e.g., example 4) relates to a previous example (e.g., one of the examples 1 to 3) or to any other example, further comprising that one of the first stage and the second stage comprises a shunt switch, and wherein the other one of the first stage and the second stage comprises a series switch.

Another example (e.g., example 5) relates to a previous example (e.g., one of the examples 1 to 4) or to any other example, further comprising an inductor coupled in parallel to at least one of the first RF switch and the second RF switch.

Another example (e.g., example 6) relates to a previous example (e.g., one of the examples 1 to 5) or to any other example, further comprising that at least one of the first stage and the second stage comprises a shunt switch and a quarter-wave transmission line.

Another example (e.g., example 7) relates to a previous example (e.g., one of the examples 1 to 6) or to any other example, further comprising that at least one of the first stage and the second stage comprises a series switch and a shunt switch.

Another example (e.g., example 8) relates to a previous example (e.g., one of the examples 1 to 7) or to any other example, further comprising a resonator coupled between the output node and the RF switch assembly.

Another example (e.g., example 9) relates to a previous example (e.g., one of the examples 1 to 8) or to any other example, further comprising a transformer coupled between the output node and the RF switch assembly.

Another example (e.g., example 10) relates to a previous example (e.g., one of the examples 1 to 9) or to any other example, further comprising a second output node configured to output the RF signal, a second RF switch assembly coupled between the input node and the second output node, wherein the second RF switch assembly comprises a third stage comprising a third RF switch, and a fourth stage comprising a fourth RF switch.

An example (e.g., example 11) relates to an RF system, comprising an RF circuit according to a previous example (e.g., one of the examples 1 to 10), and an antenna coupled to one of the output node and the input node, wherein the antenna is configured to receive and/or generate the RF signal.

Another example (e.g., example 12) relates to a previous example (e.g., example 11) or to any other example, further comprising at least one of an amplifier circuit and a passive mixer coupled to the other one of the output node and the input node.

Another example (e.g., example 13) relates to a previous example (e.g., example 12) or to any other example, further comprising a plurality of RF circuits according to any one of examples 1 to 10 coupled to the at least one of the amplifier circuit and the passive mixer, and a plurality of antennas, each coupled to a respective RF circuit of the plurality of RF circuits.

Another example (e.g., example 14) relates to a previous example (e.g., one of the examples 12 or 13) or to any other example, further comprising that the amplifier circuit comprises a power amplifier or a low-noise amplifier.

Another example (e.g., example 15) relates to a previous example (e.g., one of the examples 11 to 14) or to any other example, further comprising that the RF circuit is a time division duplex switch.

An example (e.g., example 16) relates to a method for an RF circuit, the RF circuit comprising an RF switch assembly comprising a first stage and a second stage coupled between an input node and an output node, the first stage comprising a first RF switch and the second stage comprising a second RF switch, the method comprising receiving, at the input node, an RF signal, selectively connecting or disconnecting, by the RF switch assembly, the input node and the output node, selectively outputting, at the output node, the RF signal, and in an off state of the RF switch assembly in which the first stage and the second stage are in an off state, attenuating, at the first stage, a signal power of the RF signal or isolating, at the first stage, the output node against the input node.

The aspects and features described in relation to a particular one of the previous examples may also be combined with one or more of the further examples to replace an identical or similar feature of that further example or to additionally introduce the features into the further example.

Examples may further be or relate to a (computer) program including a program code to execute one or more of the above methods when the program is executed on a computer, processor or other programmable hardware component. Thus, steps, operations or processes of different ones of the methods described above may also be executed by programmed computers, processors or other programmable hardware components. Examples may also cover program storage devices, such as digital data storage media, which are machine-, processor- or computer-readable and encode and/or contain machine-executable, processor-executable or computer-executable programs and instructions. Program storage devices may include or be digital storage devices, magnetic storage media such as magnetic disks and magnetic tapes, hard disk drives, or optically readable digital data storage media, for example. Other examples may also include computers, processors, control units, (field) programmable logic arrays ((F)PLAs), (field) programmable gate arrays ((F)PGAs), graphics processor units (GPU), application-specific integrated circuits (ASICs), integrated circuits (ICs) or system-on-a-chip (SoCs) systems programmed to execute the steps of the methods described above.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, - functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A radiofrequency, RF, circuit (100) comprising:
an input node (110) configured to receive an RF signal;
an output node (120) configured to output the RF signal;
an RF switch assembly (130) coupled between the input node (110) and the output node (120), wherein the RF switch assembly (130) is configured to selectively connect or disconnect the input node (110) and the output node (120), and wherein the RF switch assembly (130) comprises:
a first stage (130-1) comprising a first RF switch (140-1); and
a second stage (130-2) comprising a second RF switch (140-2), wherein the first stage (130-1) is configured, in an off state of the RF switch assembly (130) in which the first stage (130-1) and the second stage (130-2) are in an off state, to attenuate a signal power of the RF signal or isolate the output node (120) against the input node (110).

2. The RF circuit (100) of claim 1, wherein the first stage (130-1) and the second stage (130-2) are directly coupled to one another, the first stage (130-1) and the second stage (130-2) being adjacent within the RF circuit (100).

3. The RF circuit (100) of any one of the previous claims, wherein at least one of the first stage (130-1) and the second stage (130-2) comprises a shunt switch (232) or a series switch (235).

4. The RF circuit (100) of any one of the previous claims, wherein one of the first stage (130-1) and the second stage (130-2) comprises a shunt switch (232), and wherein the other one of the first stage (130-1) and the second stage (130-2) comprises a series switch (235).

5. The RF circuit (100) of any one of the previous claims, further comprising an inductor (233) coupled in parallel to at least one of the first RF switch (140-1) and the second RF switch (140-2).

6. The RF circuit (100) of any one of the previous claims, wherein at least one of the first stage (130-1) and the second stage (130-2) comprises a shunt switch (232) and a quarter-wave transmission line (231).

7. The RF circuit (100) of any one of the previous claims, wherein at least one of the first stage (130-1) and the second stage (130-2) comprises a series switch (235) and a shunt switch (232).

8. The RF circuit (100) of any one of the previous claims, further comprising a resonator (370-1, 370-2) coupled between the output node (120) and the RF switch assembly (130).

9. The RF circuit (100) of any one of the previous claims, further comprising a transformer (480-1, 480-2) coupled between the output node (120) and the RF switch assembly (130).

10. The RF circuit (100) of any one of the previous claims, further comprising:
a second output node (250) configured to output the RF signal;
a second RF switch assembly (235) coupled between the input node (110) and the second output node (250), wherein the second RF switch assembly (235) comprises:
a third stage (230-3) comprising a third RF switch (240-3); and
a fourth stage (230-4) comprising a fourth RF switch (240-4).

11. A radiofrequency, RF, system (500), comprising:
an RF circuit (505) according to any one of the previous claims; and
an antenna (590) coupled to one of the output node and the input node, wherein the antenna (590) is configured to receive and/or generate the RF signal.

12. The RF system (500) of claim 11, further comprising at least one of an amplifier circuit (630) and a passive mixer coupled to the other one of the output node and the input node.

13. The RF system (500) of claim 12, further comprising:
a plurality of RF circuits (610-1 to 610-5) according to any one of claims 1 to 10 coupled to the at least one of the amplifier circuit (630, 640) and the passive mixer; and
a plurality of antennas (620-1 to 620-5), each coupled to a respective RF circuit of the plurality of RF circuits (610-1 to 610-5).

14. The RF system (500) of any one of claims 11 to 13, wherein the RF circuit (505) is a time division duplex switch (720).

15. A method (800) for a radio frequency, RF, circuit, the RF circuit comprising an RF switch assembly comprising a first stage and a second stage coupled between an input node and an output node, the first stage comprising a first RF switch and the second stage comprising a second RF switch, the method comprising:
receiving (810), at the input node, an RF signal;
selectively connecting (820) or disconnecting (820), by the RF switch assembly, the input node and the output node;
selectively outputting (830), at the output node, the RF signal; and
in an off state of the RF switch assembly in which the first stage and the second stage are in an off state, attenuating (840), at the first stage, a signal power of the RF signal or isolating (840), at the first stage, the output node against the input node.

## Amended claims

### Amended claims in accordance with Rule 137(2) EPC.

1. A radiofrequency, RF, circuit (100) comprising:
an input node (110) configured to receive an RF signal;
an output node (120) configured to output the RF signal;
an RF switch assembly (130) coupled between the input node (110) and the output node (120), wherein the RF switch assembly (130) is configured to selectively connect or disconnect the input node (110) and the output node (120), and wherein the RF switch assembly (130) comprises:
a first stage (130-1) comprising a first RF switch (140-1); and
a second stage (130-2) comprising a second RF switch (140-2), wherein at least one of the first stage (130-1) and the second stage (130-2) comprises a shunt switch (232) and a quarter-wave transmission line (231), and wherein the first stage (130-1) is configured, in an off state of the RF switch assembly (130) in which the first stage (130-1) and the second stage (130-2) are in an off state, to attenuate a signal power of the RF signal or isolate the output node (120) against the input node (110).

2. The RF circuit (100) of claim 1, wherein the first stage (130-1) and the second stage (130-2) are directly coupled to one another, the first stage (130-1) and the second stage (130-2) being adjacent within the RF circuit (100).

3. The RF circuit (100) of any one of the previous claims, wherein at least one of the first stage (130-1) and the second stage (130-2) comprises a shunt switch (232) or a series switch (235).

4. The RF circuit (100) of any one of the previous claims, wherein one of the first stage (130-1) and the second stage (130-2) comprises a shunt switch (232), and wherein the other one of the first stage (130-1) and the second stage (130-2) comprises a series switch (235).

5. The RF circuit (100) of any one of the previous claims, further comprising an inductor (233) coupled in parallel to at least one of the first RF switch (140-1) and the second RF switch (140-2).

6. The RF circuit (100) of any one of the previous claims, wherein at least one of the first stage (130-1) and the second stage (130-2) comprises a series switch (235) and a shunt switch (232).

7. The RF circuit (100) of any one of the previous claims, further comprising a resonator (370-1, 370-2) coupled between the output node (120) and the RF switch assembly (130).

8. The RF circuit (100) of any one of the previous claims, further comprising a transformer (480-1, 480-2) coupled between the output node (120) and the RF switch assembly (130).

9. The RF circuit (100) of any one of the previous claims, further comprising:
a second output node (250) configured to output the RF signal;
a second RF switch assembly (235) coupled between the input node (110) and the second output node (250), wherein the second RF switch assembly (235) comprises:
a third stage (230-3) comprising a third RF switch (240-3); and
a fourth stage (230-4) comprising a fourth RF switch (240-4).

10. A radiofrequency, RF, system (500), comprising:
an RF circuit (505) according to any one of the previous claims; and
an antenna (590) coupled to one of the output node and the input node, wherein the antenna (590) is configured to receive and/or generate the RF signal.

11. The RF system (500) of claim 10, further comprising at least one of an amplifier circuit (630) and a passive mixer coupled to the other one of the output node and the input node.

12. The RF system (500) of claim 11, further comprising:
a plurality of RF circuits (610-1 to 610-5) according to any one of claims 1 to 9 coupled to the at least one of the amplifier circuit (630, 640) and the passive mixer; and
a plurality of antennas (620-1 to 620-5), each coupled to a respective RF circuit of the plurality of RF circuits (610-1 to 610-5).

13. The RF system (500) of any one of claims 10 to 12, wherein the RF circuit (505) is a time division duplex switch (720).

14. A method (800) for a radio frequency, RF, circuit, the RF circuit comprising an RF switch assembly comprising a first stage and a second stage coupled between an input node and an output node, the first stage comprising a first RF switch and the second stage comprising a second RF switch, wherein at least one of the first stage and the second stage comprises a shunt switch and a quarter-wave transmission line, the method comprising:
receiving (810), at the input node, an RF signal;
selectively connecting (820) or disconnecting (820), by the RF switch assembly, the input node and the output node;
selectively outputting (830), at the output node, the RF signal; and
in an off state of the RF switch assembly in which the first stage and the second stage are in an off state, attenuating (840), at the first stage, a signal power of the RF signal or isolating (840), at the first stage, the output node against the input node.
